# DEMANDE DE BREVET EUROPEEN

(11) **EP 4 009 354 A1**
(43) Date de publication de la demande: **08.06.2022**
(21) Numéro de dépôt: 21211092.8
(22) Date de dépôt: 29.11.2021
(51) Int. Cl.: H01L 21/67, H01L 21/677, H01L 21/683

(54) **OUTIL DE TRANSFERT COLLECTIF DE MICROPUCES D'UN SUBSTRAT SOURCE VERS UN SUBSTRAT DESTINATION**

(30) Priorité: 03.12.2020 FR 2012635
(71) Demandeur: Commissariat à l'Energie Atomique et aux Energies Alternatives, 75015 Paris (FR)
(72) Inventeur: CAPLET, Stéphane, 38054 GRENOBLE CEDEX 9 (FR)
(74) Mandataire: Cabinet Beaumont

(57) **Abrégé**

La présente description concerne un outil (100) de transfert collectif de micropuces d'un substrat source vers un substrat destination, ledit outil comprenant une plaque (101) comportant des première (101a) et deuxième (101b) faces opposées, et, du côté de la première face, une pluralité de zones d'accueil de micropuces, la plaque (101) comprenant une ouverture traversante (103) en vis-à-vis de chaque zone d'accueil.

## Description

### Domaine technique

La présente description concerne de façon générale le domaine de l'assemblage de micropuces sur un substrat, par exemple en vue de la réalisation d'un dispositif d'affichage d'images émissif à diodes électroluminescentes (LED), par exemple un écran de télévision, d'ordinateur, de smartphone, de tablette numérique, etc.

### Technique antérieure

Il a déjà été proposé, dans la demande de brevet EP3381060, un procédé de fabrication d'un dispositif d'affichage d'images comportant une pluralité de micropuces électroniques élémentaires disposées en matrice sur un même substrat de report. Selon ce procédé, les micropuces et le substrat de report sont fabriqués séparément. Chaque micropuce comprend un empilement d'une LED et d'un circuit de commande de la LED. Le circuit de commande comprend une face de connexion opposée à la LED, comprenant des plages de connexion électrique destinées à être connectées au substrat de report pour la commande de la micropuce. Le substrat de report comprend une face de connexion comportant, pour chaque micropuce, des plages de connexion électrique destinées à être connectées respectivement aux plages de connexion électrique de la micropuce. Les puces sont ensuite rapportées sur le substrat de report, faces de connexion tournées vers la face de connexion du substrat de report, et fixées sur le substrat de report de façon à connecter les plages de connexion électrique de chaque micropuce aux plages de connexion électrique correspondantes du substrat de report.

Du fait des dimensions relativement petites des micropuces, leur assemblage sur le substrat de report est délicat à réaliser.

### Résumé de l'invention

Un mode de réalisation prévoit un outil de transfert collectif de micropuces d'un substrat source vers un substrat destination, ledit outil comprenant une plaque comportant des première et deuxième faces opposées, et, du côté de la première face, une pluralité de zones d'accueil de micropuces, la plaque comprenant une ouverture traversante en vis-à-vis de chaque zone d'accueil.

Selon un mode de réalisation, chaque ouverture traversante est adaptée à canaliser un flux d'aspiration généré du côté de la deuxième face de la plaque, de façon à maintenir une micropuce plaquée contre chaque zone d'accueil.

Selon un mode de réalisation, la plaque comprend, du côté de sa première face, dans chaque zone d'accueil, un bossage entourant au moins partiellement l'ouverture.

Selon un mode de réalisation, dans chaque zone d'accueil, le bossage forme un cadre entourant entièrement l'ouverture traversante et délimitant latéralement une cavité dans laquelle débouche l'ouverture traversante.

Selon un mode de réalisation, la plaque comprend, du côté de sa première face, dans chaque zone d'accueil, un ou plusieurs piliers de soutènement s'étendant dans la cavité délimitée latéralement par le bossage.

Selon un mode de réalisation, la plaque présente, du côté de sa première face, une rugosité comprise entre 10 et 50 nm.

Selon un mode de réalisation, la plaque comprend, du côté de sa deuxième face, une cavité commune dans laquelle débouchent les ouvertures traversantes, ladite cavité étant destinée à être reliée à une source d'aspiration.

Selon un mode de réalisation, la plaque comprend, du côté de sa deuxième face, un ou plusieurs piliers de soutènement s'étendant dans la cavité commune.

Selon un mode de réalisation, la plaque comprend un empilement d'un substrat en un matériau semiconducteur, d'une couche diélectrique et d'une couche semiconductrice.

Selon un mode de réalisation, chaque ouverture traversante comprend une première partie s'étendant à travers le substrat et la couche diélectrique et une deuxième partie s'étendant à travers la couche semiconductrice, la première partie présentant des dimensions latérales supérieures aux dimensions latérales de la deuxième partie.

Un autre mode de réalisation prévoit un dispositif de transfert collectif de micropuces d'un substrat source vers un substrat destination, comportant un outil de transfert tel que défini ci-dessus, et un support de maintien de l'outil, le support étant adapté à connecter collectivement les ouvertures traversantes à une source d'aspiration.

Selon un mode de réalisation, l'outil de transfert est maintenu fixé au support par aspiration au moyen d'une deuxième source d'aspiration.

Un autre mode de réalisation prévoit un procédé de transfert de micropuces d'un substrat source vers un substrat destination au moyen d'un outil de transfert tel que défini ci-dessus, dans lequel chaque micropuce comprend une LED et un circuit de commande de la LED.

### Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :
la figure 1A est une vue de dessous représentant de façon schématique un exemple d'un outil de transfert de micropuces d'un substrat source vers un substrat destination selon un mode de réalisation ;
la figure 1B est une vue en coupe de l'outil de la figure 1A ;
la figure 1C est une autre vue en coupe de l'outil de la figure 1A ;
la figure 1D est une vue de dessus de l'outil de la figure 1A ;
la figure 2 est une vue en coupe représentant de façon schématique un dispositif de transfert comportant un outil de transfert du type décrit en relation avec les figures 1A, 1B, 1C et 1D ;
la figure 3 est une vue de dessous représentant de façon schématique un support d'outil du dispositif de la figure 2 ;
la figure 4 est une vue en coupe représentant de façon schématique un autre exemple d'un outil de transfert de micropuces d'un substrat source vers un substrat destination selon un mode de réalisation ;
la figure 5A est une vue en coupe représentant de façon schématique et partielle une variante de réalisation de l'outil de transfert des figures 1A, 1B, 1C et 1D ;
la figure 5B est une vue de dessous de l'outil de la figure 5A ;
la figure 6A est une vue en coupe représentant de façon schématique et partielle une autre variante de réalisation de l'outil de transfert des figures 1A, 1B, 1C et 1D ; et
la figure 6B est une vue de dessous de l'outil de la figure 6A.

### Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les diverses applications pouvant tirer profit des outils de transfert décrits n'ont pas été détaillées.

Sauf précision contraire, lorsque l'on fait référence à deux éléments connectés entre eux, cela signifie directement connectés sans éléments intermédiaires autres que des conducteurs, et lorsque l'on fait référence à deux éléments reliés (en anglais "coupled") entre eux, cela signifie que ces deux éléments peuvent être connectés ou être reliés par l'intermédiaire d'un ou plusieurs autres éléments.

Dans la description qui suit, lorsque l'on fait référence à des qualificatifs de position absolue, tels que les termes "avant", "arrière", "haut", "bas", "gauche", "droite", etc., ou relative, tels que les termes "dessus", "dessous", "supérieur", "inférieur", etc., ou à des qualificatifs d'orientation, tels que les termes "horizontal", "vertical", etc., il est fait référence sauf précision contraire à l'orientation des vues en coupe des figures.

Sauf précision contraire, les expressions "environ", "approximativement", "sensiblement", et "de l'ordre de" signifient à 10 % près, de préférence à 5 % près.

On s'intéresse ici plus particulièrement à la réalisation d'un outil de transfert permettant de transférer collectivement (simultanément) une pluralité de micropuces disjointes depuis un substrat source vers un substrat destination.

A titre d'exemple, les micropuces sont formées à partir d'une même tranche semiconductrice. Les micropuces sont par exemple toutes identiques, aux dispersions de fabrication près. Le substrat source peut être un film support, par exemple un film adhésif, sur lequel reposent les micropuces à l'issue d'une étape de singularisation. A titre d'exemple, les micropuces peuvent être des pixels élémentaires d'un écran d'affichage. Chaque micropuce peut par exemple comprendre uniquement une LED, ou une LED et un circuit de commande de la LED, ou une pluralité de LED et un circuit de commande de ladite pluralité de LED. A titre d'exemple, chaque micropuce comprend un empilement d'une LED et d'un circuit de commande de la LED, tel que décrit dans la demande de brevet EP3381060 susmentionnée.

Selon un aspect des modes de réalisation décrits, l'outil de transfert est adapté à prélever simultanément, par aspiration, une pluralité de micropuces sur le substrat source, puis à reporter sur un substrat destination ou substrat de report les micropuces prélevées.

Le substrat de report comprend par exemple une face de connexion comportant, pour chaque micropuce, une ou plusieurs plages de connexion électrique destinées à être connectées respectivement à des plages de connexion électrique correspondantes de la micropuce. Les micropuces peuvent être rapportées sur le substrat de report, faces de connexion tournées vers la face de connexion du substrat de report, au moyen de l'outil de transfert. L'outil de transfert peut être appliqué à la manière d'un tampon contre la face de connexion du substrat de report, de façon à fixer les micropuces sur le substrat de report et connecter électriquement les plages de connexion des micropuces aux plages de connexion correspondantes du substrat de report. L'outil de transfert peut ensuite être retiré, en laissant les micropuces en place sur le substrat de report.

A titre de variante, l'outil de transfert peut être utilisé pour réaliser un transfert collectif de micropuces d'un substrat source vers un substrat destination, sans connexion électrique des micropuces sur le substrat destination. Dans ce cas, les micropuces peuvent ne pas comporter de plages de connexion électrique du côté de leur face tournée vers le substrat destination. Les micropuces peuvent par exemple être collées sur le substrat destination au moyen d'une couche adhésive.

Le pas des micropuces (c'est-à-dire la distance centre à centre entre deux micropuces voisines) sur le substrat de report peut être un multiple, par exemple supérieur à 1, du pas des micropuces sur le substrat source. Le pas des micropuces sur l'outil de transfert est par exemple égal au pas des micropuces sur le substrat de report.

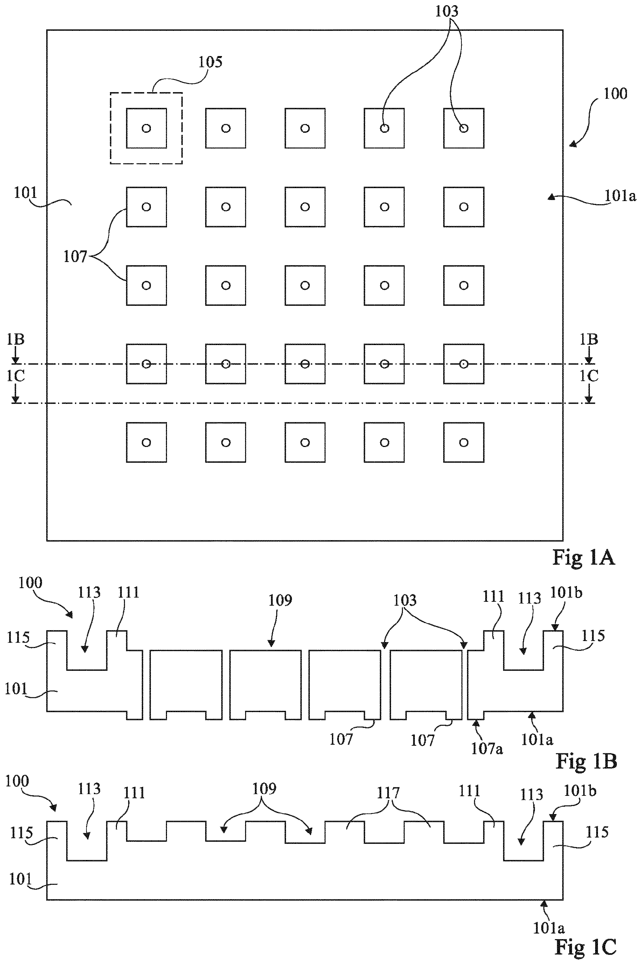

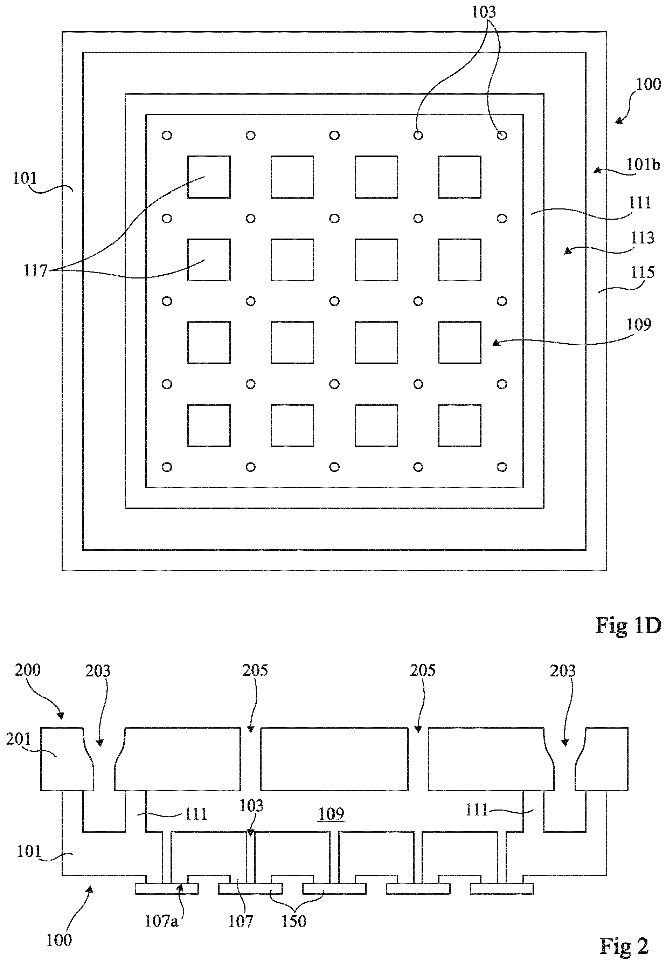

Les figures 1A, 1B, 1C et 1D représentent de façon schématique un exemple d'un outil 100 de transfert de micropuces d'un substrat source vers un substrat destination selon un mode de réalisation. La figure 1A est une vue de dessous de l'outil de transfert. La figure 1B est une vue en coupe selon le plan 1B-1B de la figure 1A. La figure 1C est une vue en coupe selon le plan 1C-1C de la figure 1A. La figure 1D est une vue de dessus de l'outil de transfert.

L'outil de transfert 100 comprend une plaque 101, par exemple en un matériau semiconducteur, par exemple en silicium. La plaque 101 comprend des première et deuxième faces principales opposées 101a et 101b, correspondant respectivement à la face inférieure et à la face supérieure dans l'orientation des vues en coupe des figures 1B et 1C. L'épaisseur de la plaque 101 est par exemple comprise entre 300 µm et 1 mm, par exemple de l'ordre de 725 µm. Les dimensions latérales de la plaque 101 sont par exemple comprises entre 1 mm et 10 cm. En vue de dessus ou de dessous, la plaque 101 a par exemple une forme générale carrée ou rectangulaire. Les modes de réalisation décrits ne se limitent toutefois pas à ce cas particulier.

La plaque 101 comprend une pluralité d'ouvertures traversantes 103 s'étendant verticalement de la face supérieure 101b à la face inférieure 101a de la plaque. Chaque ouverture 103 présente, du côté de la face 101a, des dimensions latérales inférieures aux dimensions des micropuces à manipuler, par exemple des dimensions latérales au moins deux fois et de préférence au moins 5 fois plus petites que les dimensions latérales des micropuces. A titre d'exemple les micropuces à manipuler ont des dimensions latérales comprises entre 5 et 500 µm, par exemple entre 5 et 100 µm, par exemple entre 5 et 50 µm. Les dimensions latérales des ouvertures 103 au niveau de la face inférieure 101a de la plaque 101 sont par exemple comprises entre 1 et 100 µm, par exemple entre 5 et 50 µm.

Les ouvertures 103 forment des trous d'aspiration permettant de saisir les micropuces sur un substrat source, et de les transférer vers un substrat destination. Plus particulièrement, lors d'une opération de transfert, de l'air est aspiré à travers les ouvertures 103 depuis la face supérieure 101b de la plaque 101, au moyen d'une source d'aspiration (non représentée). La plaque 101 est alors placée en vis-à-vis du substrat source, face inférieure 101a tournée vers les micropuces, et approchée des micropuces, par exemple jusqu'à venir au contact de la face des micropuces opposée au substrat source. Les micropuces situées en vis-à-vis des ouvertures 103 de la plaque 101 sont alors plaquées, par aspiration, contre la face inférieure 101a de la plaque 101. Lorsque l'outil de transfert est éloigné du substrat source, les micropuces ainsi aspirées se désolidarisent du substrat source et restent plaquées contre la face inférieure de la plaque 101. Les micropuces qui ne sont pas situées en vis-à-vis des trous d'aspiration 103 restent en revanche sur le substrat source. L'outil de transfert est alors déplacé jusqu'au substrat destination, par exemple au moyen d'un bras motorisé (non représenté), puis appliqué contre le substrat destination, face inférieure tournée vers la face d'accueil ou face de connexion du substrat destination. Les micropuces sont ainsi mise en contact, par leur face opposée à la plaque 101, avec la face d'accueil du substrat destination. La source d'aspiration peut alors être interrompue pour relâcher les micropuces, qui restent ainsi sur le substrat destination lors du retrait de l'outil de transfert.

Un avantage de ce mode de transfert est de permettre de transférer collectivement une pluralité de micropuces sur un substrat destination, ce qui peut être avantageux notamment pour la réalisation d'écrans d'affichage du type décrit dans la demande de brevet EP3381060 susmentionnée. En outre, l'outil de transfert permet d'exercer une pression sur les micropuces lors de leur application sur le substrat destination. Ceci peut être avantageux pour fixer et connecter électriquement les micropuces au substrat destination. Ceci est notamment avantageux dans le cas où les micropuces sont munies, du côté de leur face de connexion au substrat destination, de microinserts, par exemple des microtubes, en un matériau électriquement conducteur, par exemple en tungstène, par exemple formés par un procédé du type décrit dans la demande de brevet US2011/094789, destinés à être insérés par pression dans des plages de connexion électrique du substrat destination. A titre de variante, les microinserts peuvent être formés sur la face de connexion du substrat destination et s'insérer, par pression, dans des plages de connexion électrique des micropuces.

La plaque 101 comprend, du côté de sa face inférieure, une pluralité de zones d'accueil 105 destinées à recevoir chacune une micropuce dans un rapport de 1 pour 1 (une unique micropuce par zone d'accueil et une unique zone d'accueil par micropuce). Dans cet exemple, la plaque 101 comprend une unique ouverture traversante 103 en vis-à-vis de chaque zone d'accueil 105. Les dimensions latérales des zones d'accueil sont sensiblement égales aux dimensions latérales des micropuces à manipuler. Le pas des zones d'accueil (c'est-à-dire la distance centre à centre entre deux zones d'accueil voisines) définit le pas des micropuces sur l'outil de transfert. Ce pas est par exemple égal ou sensiblement égal au pas des micropuces sur le substrat destination. A titre d'exemple, le pas des micropuces sur l'outil de transfert est compris entre 100 et 500 µm, par exemple de l'ordre de 200 µm. Les zones d'accueil 105 des micropuces sont par exemple agencées en matrice selon des rangées et des colonnes. Dans l'exemple représenté, l'outil de transfert comprend une matrice de 5 par 5 zones d'accueil 105, soit une capacité de transfert de 25 micropuces simultanément. Les modes de réalisation décrits ne se limitent bien entendu pas à ce cas particulier.

Dans l'exemple des figures 1A à 1D, dans chaque zone d'accueil 105, la plaque 101 présente, du côté de sa face inférieure 101a, un bossage 107 en saillie de la face 101a, entourant au moins partiellement l'ouverture 103. Dans l'exemple représenté, chaque bossage 107 a une forme carrée (en vue de dessous), le centre de l'ouverture 103 coïncidant sensiblement avec le centre du carré. Les bossages 107 peuvent toutefois avoir toute autre forme. De plus, chaque zone d'accueil 105 peut comporter plusieurs bossages 107 disjoints. Les dimensions latérales des bossages 107 sont par exemple inférieures ou égales aux dimensions latérales des micropuces à manipuler. A titre de variante, les dimensions latérales des bossages 107 sont légèrement supérieures aux dimensions latérales des micropuces. Par exemple, les dimensions latérales des bossages 107 sont supérieures de 0,5 à 5 µm aux dimensions latérales des micropuces.

Un avantage lié à la prévision des bossages 107 est que, lorsque l'outil de transfert 100 est mis en contact avec les micropuces du substrat source, seules les micropuces situées en vis-à-vis d'une ouverture 103 viennent en contact avec la face inférieure 101a de la plaque 101, au niveau de la face inférieure 107a des bossages 107. Ceci évite tout risque de prélèvement accidentel des autres micropuces sur le substrat source (par exemple par interaction électrostatique, forces de van der Waals, etc.). La hauteur (épaisseur) des bossages 107 est par exemple comprise entre 100 nm et 20 µm.

A titre de variante, les bossages 107 peuvent être omis, la face inférieure de la plaque 101 étant alors sensiblement plane.

Toujours afin de limiter les risques d'adhérence indésirable des micropuces, la face inférieure de la plaque 101 peut présenter une rugosité contrôlée, par exemple une rugosité de l'ordre de 10 à 50 nm. En dehors des zones d'accueil 105, une telle rugosité permet de limiter les risques de prélèvement accidentel de micropuces sur le substrat source. A l'intérieur des zones d'accueil (et en particulier, en présence des bossages 107, sur la face de contact 107a des bossages), une telle rugosité permet de faciliter la libération des micropuces (notamment en limitant le risque d'avoir des forces van der Waals résiduelles qui retiendraient la micropuce que l'on souhaite relâcher) et leur dépôt sur le substrat destination lorsque l'aspiration est interrompue. La rugosité de la face inférieure de la plaque 101 peut par exemple être obtenue par photolithographie et gravure, par traitement chimique, ou encore par dépôt d'une couche supplémentaire (non représentée) de rugosité contrôlée.

Dans l'exemple des figures 1A à 1D, la plaque 101 présente, du côté de sa face supérieure 101b, une cavité 109 dans laquelle débouchent les ouvertures traversantes 103. La cavité 109 permet de distribuer le flux d'aspiration dans les différentes ouvertures 103. La cavité 103 est délimitée latéralement par un mur périphérique 111, assurant l'étanchéité de l'aspiration. A titre de variante, la cavité 109 peut être remplacée par un réseau de canaux de distribution du flux d'aspiration, reliant les unes aux autres les ouvertures traversantes 103 du côté de la face supérieure 101b de la plaque 101. La profondeur de la cavité 109 est par exemple comprise entre 10 et 300 µm.

L'outil de transfert 100 est destiné à être monté sur un chargeur ou support 200 permettant notamment de maintenir et manipuler l'outil, et de relier la cavité 109 à une source d'aspiration.

La figure 2 est une vue en coupe représentant de façon schématique l'outil de transfert 100, monté sur le support 200. On a en outre représenté des micropuces 150 maintenues plaquées contre les bossages 107 des zones d'accueil 105, par aspiration via les ouvertures 103 et la cavité 109.

Dans cet exemple, le support 200 comprend une plaque 201 fermant la cavité 109 par sa face supérieure. Plus particulièrement, dans l'exemple représenté, la plaque 201 prend appui, par sa face inférieure, contre la face supérieure du mur périphérique 111 de l'outil de transfert 100.

L'outil de transfert 100 peut être fixé au support 200 par tout moyen de fixation adapté, par exemple par aimantation, par aspiration, au moyen de pinces ou clips de serrage, etc.

Dans l'exemple représenté, l'outil de transfert 100 est adapté à être fixé au support 200 par aspiration. Pour cela, l'outil de transfert 100 comprend, du côté de la face supérieure 101b de la plaque 101, un canal périphérique 113 non traversant, délimité latéralement d'une part par le mur périphérique 111, et d'autre part par un deuxième mur périphérique 115 de même hauteur que le mur 111.

Dans cet exemple, la plaque 201 du support 200 ferme le canal périphérique 113 par sa face supérieure. Plus particulièrement, dans l'exemple représenté, la plaque 201 prend appui, par sa face inférieure, contre la face supérieure des murs périphériques 111 et 115 de l'outil de transfert 100.

La plaque 201 du support 200 comporte une ou plusieurs (plusieurs dans l'exemple représenté) ouvertures traversantes 203 en vis-à-vis du canal périphérique 113 de l'outil 100. Chaque ouverture 203 est destinée à être reliée à une première source d'aspiration (non représentée), permettant de faire le vide dans le canal périphérique 113 de façon à maintenir l'outil de transfert 100 plaqué contre la face inférieure du support 200. Un conduit, non représenté, peut être prévu pour relier chaque ouverture 203 à la première source d'aspiration.

La plaque 201 du support 200 comporte en outre une ou plusieurs (plusieurs dans l'exemple représenté) ouvertures traversantes 205 en vis-à-vis de la cavité 109 de l'outil 100. Chaque ouverture 205 est destinée à être reliée à une deuxième source d'aspiration (non représentée), permettant de faire le vide dans la cavité 109 de façon à maintenir les micropuces 150 plaquées contre la face inférieure de l'outil de transfert, en vis-à-vis des ouvertures 103. Un conduit, non représenté, peut être prévu pour relier chaque ouverture 205 à la deuxième source d'aspiration.

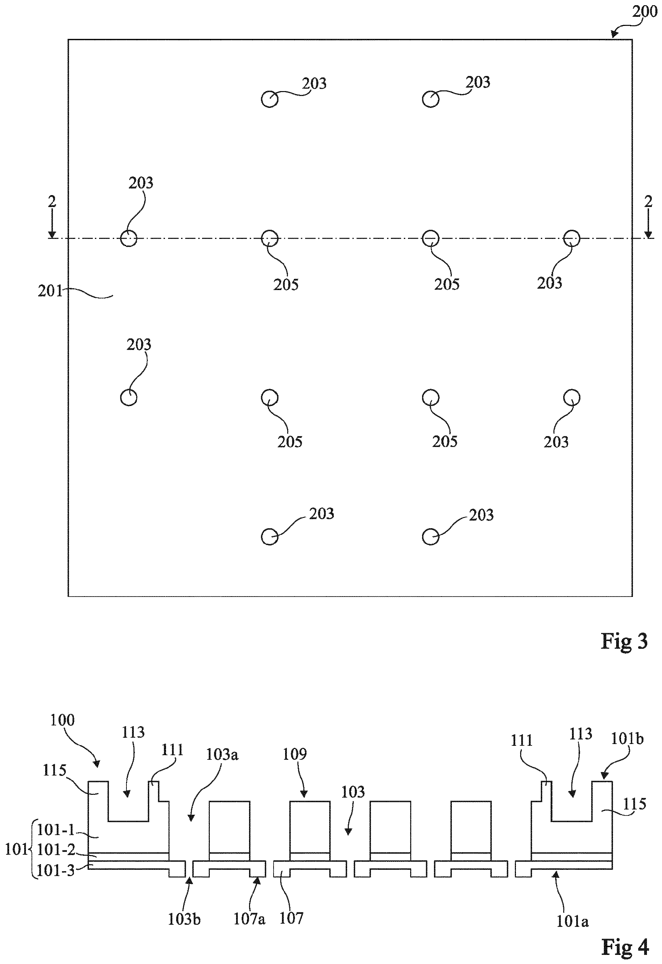

La figure 3 est une vue de dessous du support 200 de la figure 2. Le plan de coupe de la figure 2 correspond par exemple au plan 2-2 de la figure 3.

Dans l'exemple des figures 1A à 1D, l'outil de transfert comprend, du côté de la face supérieure 101b de la plaque 101, un ou plusieurs (plusieurs dans l'exemple représenté) piliers ou plots 117 de soutènement de la plaque 101. Les piliers 117 s'étendent verticalement depuis le fond de la cavité 109 jusqu'à la face supérieure de la cavité 109. Autrement dit, dans cet exemple, la face supérieure des piliers 117 est sensiblement au même niveau (coplanaire) que la face supérieure du mur périphérique 111 délimitant latéralement la cavité 109. Ainsi, lorsque l'outil de transfert 100 est monté sur le support 200, la face supérieure des piliers 117 vient en contact avec la face inférieure de la plaque 201. Ceci permet de soutenir la plaque 101 de l'outil de transfert et d'éviter qu'elle ne fléchisse sous l'effet de l'aspiration. Les piliers 117 sont de préférence régulièrement répartis sur la surface supérieure de la plaque 101. Dans l'exemple représenté, les piliers 117 ont, en vue de dessus, une forme carrée, et sont disposés en matrice selon des rangées et des colonnes. Plus généralement, les piliers 117 peuvent avoir toutes autres formes et/ou agencements permettant de soutenir la plaque 101 lors de l'aspiration. A titre de variante, les piliers de soutènement 117 peuvent être omis. Dans le cas où la cavité 109 est remplacée par un réseau de canaux de distribution du flux d'aspiration, les piliers de soutènement 117 peuvent correspondre aux murs latéraux séparant latéralement les canaux.

La figure 4 est une vue en coupe représentant plus en détail une variante de réalisation de l'outil de transfert 100 des figures 1A à 1D.

Dans cette variante, la plaque 101 est une structure de type semiconducteur sur isolant (SOI - de l'anglais "Semiconductor On Insulator"), comprenant un empilement d'un substrat semiconducteur massif 101-1, par exemple en silicium monocristallin, d'une couche diélectrique 101-2, par exemple en oxyde de silicium, et d'une couche semiconductrice 101-3, par exemple en silicium monocristallin. Dans cet exemple, la couche diélectrique 101-2 est en contact, par sa face supérieure, avec la face inférieure du substrat 101-1, et la couche semiconductrice 101-3 est en contact, par sa face supérieure, avec la face inférieure de la couche diélectrique 101-2. Le substrat 101-1 présente par exemple une épaisseur comprise entre 250 µm et 1 mm, par exemple de l'ordre de 725 µm. La couche diélectrique 101-2 présente par exemple une épaisseur comprise entre 0,4 et 4 µm. La couche semiconductrice 101-3 présente par exemple une épaisseur comprise entre 20 et 200 µm.

Dans cet exemple, la face supérieure 101b de la plaque 101 correspond à la face supérieure du substrat 101-1, et la face inférieure de la plaque 101 correspond à la face inférieure de la couche semiconductrice 101-3.

Le canal périphérique 113 de fixation de l'outil sur le support 200, ainsi que la cavité 109, sont formés dans une partie supérieure de l'épaisseur du substrat 101-1, par exemple par photolithographie et gravure, ou par toute autre méthode de micro-usinage, par exemple par gravure laser.

Dans cet exemple, chaque ouverture traversante 103 comprend une partie supérieure 103a présentant des dimensions latérales relativement importantes, par exemple comprises entre 30 et 100 µm. Dans cet exemple, la partie 103a s'étend verticalement dans le substrat 101-1 depuis le fond de la cavité 109, jusqu'à la face supérieure de la couche semiconductrice 101-3. La partie 103a est par exemple formée par photolithographie et gravure, avec arrêt sur la face supérieure de la couche diélectrique 101-2, puis retrait de la portion exposée de la couche diélectrique 101-2. Chaque ouverture 103 comprend en outre une partie inférieure 103b présentant des dimensions latérales inférieures aux dimensions latérales de la partie supérieure 103a, par exemple comprises entre 1 et 10 µm. A titre de variante (non représentée), la partie inférieure 103b de l'ouverture 103 peut comporter plusieurs trous traversants disjoints. La partie inférieure 103b s'étend verticalement depuis la face supérieure de la couche semiconductrice 101-3, au fond de la partie supérieure 103a, jusqu'à la face inférieure 101a de la couche semiconductrice 101-3. La partie 103b est par exemple formée par photolithographie et gravure, avec un masque de gravure différent de celui utilisé pour former la partie 103a. Un avantage est que ceci permet de former des ouvertures 103 présentant de très petites dimensions latérales du côté de la face inférieure 101a de la plaque 101, et ce malgré une épaisseur totale relativement importante de la plaque 101. Bien que, dans l'exemple représenté, les trous 103a et 103b soient coaxiaux, les modes de réalisation décrits ne se limitent pas à ce cas particulier. Ainsi, les trous 103a et 103b pourront être désalignés, pour autant qu'ils restent communicants.

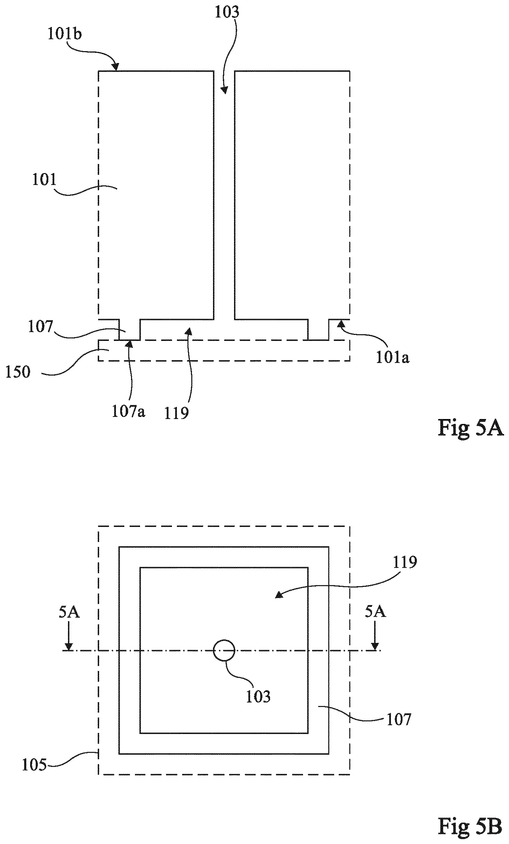

Les figures 5A et 5B illustrent une variante de réalisation de l'outil de transfert 100 décrit en relation avec les figures 1A à 1D. La figure 5B est une vue de dessous partielle agrandie de l'outil au niveau d'une zone d'accueil 105 d'une micropuce. La figure 5A est une vue en coupe selon le plan 5A de la figure 5B. Sur la figure 5A, une micropuce 150 a été représentée schématiquement par des traits en pointillés.

Dans cette variante, le bossage 107 présent du côté de la face supérieure au niveau de la zone d'accueil 105 a la forme d'un cadre entourant, en vue de dessous, l'ouverture 103. Le cadre 107 présente des dimensions latérales intérieures supérieures aux dimensions latérales de l'ouverture 103. Ainsi, le cadre 107 délimite latéralement une cavité 119 de dimensions latérales supérieures aux dimensions latérales de l'ouverture 103, dans laquelle débouche l'ouverture 103.

Les dimensions latérales du cadre 107 sont par exemple inférieures ou égales aux dimensions latérales des micropuces 150 à manipuler. Lorsqu'une micropuce est mise en contact avec la face inférieure du cadre 107, cette dernière vient fermer la cavité 119 par sa face inférieure. La cavité 119 est alors dépressurisée du fait de l'aspiration appliquée via l'ouverture 103. A titre de variante, les dimensions latérales extérieures du cadre 107 peuvent être légèrement supérieures aux dimensions latérales des micropuces, par exemple supérieures de 0,5 à 5 µm aux dimensions latérales des micropuces.

Un avantage de la variante de réalisation des figures 5A et 5B est que le cadre 107 permet d'augmenter la surface de la micropuce 150 soumise à l'aspiration, et ainsi d'améliorer la préhension des micropuces.

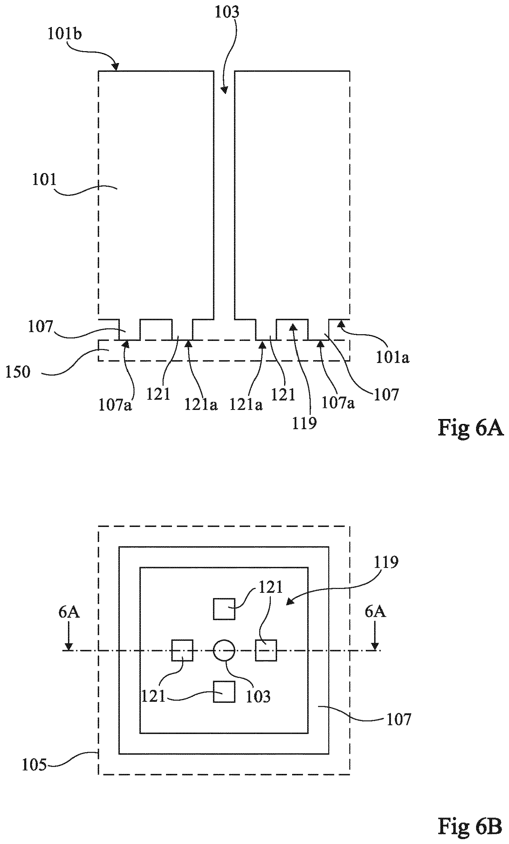

Les figures 6A et 6B illustrent une autre variante de réalisation de l'outil de transfert 100 décrit en relation avec les figures 1A à 1D. La figure 6B est une vue de dessous partielle agrandie de l'outil au niveau d'une zone d'accueil 105 d'une micropuce. La figure 6A est une vue en coupe selon le plan 6A de la figure 6B. Sur la figure 6A, une micropuce 150 a été représentée schématiquement par des traits en pointillés.

Dans cette variante, le bossage 107 présent du côté de la face supérieure au niveau de la zone d'accueil 105 a, comme dans l'exemple des figures 5A et 5B, la forme d'un cadre entourant, en vue de dessous, l'ouverture 103.

Dans la variante des figures 6A et 6B, l'outil de transfert comprend en outre, du côté de la face inférieure de la plaque 101, au niveau de chaque zone d'accueil 105, à l'intérieur du cadre 107, un ou plusieurs (plusieurs dans l'exemple représenté) piliers de soutènement 121. Les piliers 121 s'étendent verticalement depuis la face supérieure de la cavité 119 jusqu'à la face inférieure de la cavité 119. Autrement dit, dans cet exemple, la face inférieure des piliers 121 est sensiblement au même niveau (coplanaire) que la face inférieure du cadre périphérique 107. Ainsi, lorsque l'outil de transfert 100 vient en contact avec une micropuce 150, la face inférieure des piliers 121 vient en contact avec la face supérieure de la micropuce. Ceci permet de soutenir la micropuce 150 et d'éviter qu'elle ne fléchisse sous l'effet de l'aspiration. Les piliers 121 sont par exemple régulièrement répartis dans la cavité 119. Dans l'exemple représenté, les piliers 121 ont, en vue de dessous, une forme carrée. Plus généralement, les piliers 121 peuvent avoir toutes autres formes et/ou agencements permettant de soutenir la micropuce 150 lors du transfert.

A titre de variante, non représentée, dans les exemples des figures 5A et 5B d'une part, et 6A et 6B d'autre part, la profondeur de la cavité 119, c'est-à-dire la hauteur du bord latéral intérieur du cadre 107, peut être différente, par exemple inférieure, à la hauteur de saillie du bossage 107, c'est-à-dire la hauteur du bord latéral extérieur du cadre 107. A titre d'exemple, la profondeur de la cavité 119 peut être comprise entre 0,1 et 2 µm, et la hauteur de saillie du bossage 107 peut être comprise entre 0,1 et 20 µm.

Dans une variante non représentée, la cavité 119 peut être formée dans une couche mince préalablement déposée du côté de la face inférieure de la plaque 101, par exemple une couche d'oxyde de silicium ou de métal, par exemple d'épaisseur comprise entre 0,1 et 2 µm. La cavité 119 peut alors s'étendre sur toute l'épaisseur de ladite couche mince, ce qui facilite sa réalisation.

Divers modes de réalisation et variantes ont été décrits. La personne du métier comprendra que certaines caractéristiques de ces divers modes de réalisation et variantes pourraient être combinées, et d'autres variantes apparaîtront à la personne du métier. En particulier, les modes de réalisation décrits ne se limitent pas aux exemples de matériaux et de dimensions mentionnés dans la présente description.

En outre, les modes de réalisation décrits ne se limitent pas à la réalisation d'un écran d'affichage dans lequel les micropuces 150 correspondent chacune à un pixel de l'écran, mais s'appliquent plus généralement à la réalisation de tout dispositif nécessitant le report d'un grand nombre de micropuces sur un même substrat.

## Revendications

1. Outil (100) de transfert collectif de micropuces (150) d'un substrat source vers un substrat destination, ledit outil comprenant une plaque (101) comportant des première (101a) et deuxième (101b) faces opposées, et, du côté de la première face, une pluralité de zones d'accueil (105) de micropuces, la plaque (101) comprenant une ouverture traversante (103) en vis-à-vis de chaque zone d'accueil (105),
dans lequel la plaque (101) comprend, du côté de sa première face, dans chaque zone d'accueil (105), un bossage (107) entourant au moins partiellement l'ouverture (103).

2. Outil (100) selon la revendication 1, dans lequel chaque ouverture traversante (103) est adaptée à canaliser un flux d'aspiration généré du côté de la deuxième face (101b) de la plaque (101), de façon à maintenir une micropuce (150) plaquée contre chaque zone d'accueil (105).

3. Outil (100) selon l'une quelconque des revendications 1 à 3, dans lequel, dans chaque zone d'accueil (105), le bossage (107) forme un cadre entourant entièrement l'ouverture traversante (103) et délimitant latéralement une cavité (119) dans laquelle débouche l'ouverture traversante (103).

4. Outil (100) selon la revendication 3, dans lequel la plaque (101) comprend, du côté de sa première face, dans chaque zone d'accueil (105), un ou plusieurs piliers (121) de soutènement s'étendant dans la cavité (119) délimitée latéralement par le bossage (107).

5. Outil (100) selon l'une quelconque des revendications 1 à 4, dans lequel la plaque (101) présente, du côté de sa première face, une rugosité comprise entre 10 et 50 nm.

6. Outil (100) selon l'une quelconque des revendications 1 à 5, dans lequel la plaque (101) comprend, du côté de sa deuxième face (101b), une cavité commune (109) dans laquelle débouchent les ouvertures traversantes (103), ladite cavité étant destinée à être reliée à une source d'aspiration.

7. Outil (100) selon la revendication 6, dans lequel la plaque (101) comprend, du côté de sa deuxième face (101b), un ou plusieurs piliers (117) de soutènement s'étendant dans ladite cavité commune (109).

8. Outil (100) selon l'une quelconque des revendications 1 à 7, dans lequel la plaque (101) comprend un empilement d'un substrat (101-1) en un matériau semiconducteur, d'une couche diélectrique (101-2) et d'une couche semiconductrice (101-3).

9. Outil (100) selon la revendication 8, dans lequel chaque ouverture traversante (103) comprend une première partie (103a) s'étendant à travers le substrat (101-1) et la couche diélectrique (101-2) et une deuxième partie (103b) s'étendant à travers la couche semiconductrice (101-3), la première partie (103a) présentant des dimensions latérales supérieures aux dimensions latérales de la deuxième partie (103b).

10. Dispositif de transfert collectif de micropuces (150) d'un substrat source vers un substrat destination, comportant un outil de transfert (100) selon l'une quelconque des revendications 1 à 9, et un support (200) de maintien de l'outil (100), le support (200) étant adapté à connecter collectivement les ouvertures traversantes (103) à une source d'aspiration.

11. Dispositif selon la revendication 10, dans lequel l'outil de transfert (100) est maintenu fixé au support (200) par aspiration au moyen d'une deuxième source d'aspiration.

12. Procédé de transfert de micropuces (150) d'un substrat source vers un substrat destination au moyen d'un outil de transfert (100) selon l'une quelconque des revendications 1 à 9, dans lequel chaque micropuce (150) comprend une LED et un circuit de commande de la LED.
